Europäisches Patentamt

(19) European Patent Office

Office européen des brevets

(11) Publication number: **0 447 242 A2**

(12) **EUROPEAN PATENT APPLICATION**

(21) Application number: 91302182.0

(51) Int. Cl.⁵: **G11C 7/00**

(22) Date of filing: **14.03.91**

(30) Priority: 16.03.90 JP 67604/90

(43) Date of publication of application:
18.09.91 Bulletin 91/38

(84) Designated Contracting States:
DE FR GB

(71) Applicant: **FUJITSU LIMITED**
**1015, Kamikodanaka Nakahara-ku**
**Kawasaki-shi Kanagawa 211 (JP)**

(72) Inventor: **Ueno, Kouji**
**139-4-1211, Ohmaru**
**Inagi-shi, Tokyo, 206 (JP)**
Inventor: **Tsuchimoto, Yuji**
**7652, Mukaishimacho**
**Mitsuki-gun, Hiroshima, 722 (JP)**
Inventor: **Mutoh, Yoshikazu**
**1476-3, Shimokodanaka, Nakahara-ku**
**Kawasaki-shi, Kanagawa, 211 (JP)**

(74) Representative: **Billington, Lawrence Emlyn et al**
**HASELTINE LAKE & CO Hazlitt House 28**
**Southampton Buildings Chancery Lane**
**London WC2A 1AT (GB)**

(54) **Semiconductor integrated circuit device having output stabilizing means.**

(57)    A semiconductor integrated circuit device includes a memory cell array (28), an addressing part (21, 22, 24, 25), and a detection circuit (27) for detecting a change in an address signal and for outputting an ATD pulse having a predetermined pulse width when the change is detected. The device also includes a sense amplifier (30) for amplifying information read out from the memory cell array and for outputting an amplified information signal, and an output part (91, 191A) for setting an output terminal (OUT) to either a first level or a second level in response to the amplified information signal. Further, the device includes an intermediate level generating circuit (75, 93 ; 191B) for setting the output terminal to an intermediate level during a period corresponding to the pulse width of the ATD pulse, the intermediate level being lower than the first level and higher than the second level.

EP 0 447 242 A2

FIG.6

## SEMICONDUCTOR INTEGRATED CIRCUIT DEVICE HAVING OUTPUT STABILIZING MEANS

### BACKGROUND OF THE INVENTION

The present invention generally relates to a semiconductor integrated circuit device, and more particularly to an improvement in stabilization of the output of the device.

As the integration density is increasing, it becomes more necessary to provide a semiconductor integrated circuit device which has little noise and which operates correctly at a high speed.

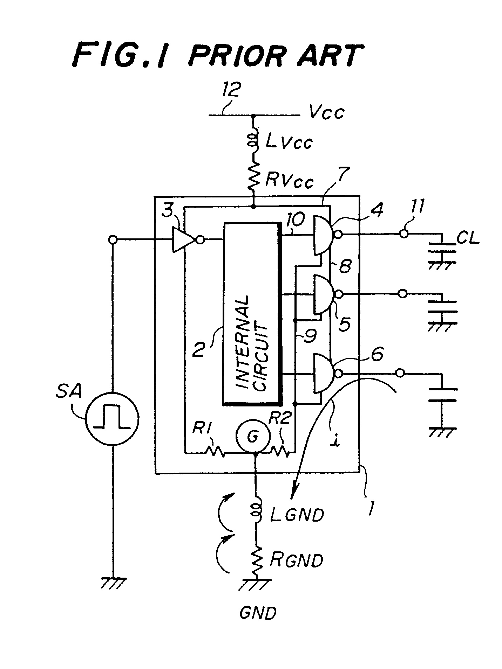

FIG.1 is a circuit diagram of a conventional Bi-CMOS type PROM (Programmable Read Only Memory) which has a TTL (Transistor Transistor Logic) type output circuit. A PROM chip 1 has an internal circuit 2, an address buffer 3, and output buffers 4 - 6. Further, the PROM chip 1 has a power supply line 7, a ground line 8, an output enable signal line 9, resistors R1 and R2 of internal wiring lines, a ground terminal G and signal lines 10. An address signal (input signal) SA from an external circuit is input to the internal circuit 2 via the address buffer 3. The internal circuit 2 decodes the address signal SA and outputs memory information related to the address signal SA. The memory information read out from the internal circuit 2 is output to external pins 11 via the output buffers 4 - 6. External loads (capacitors) $C_L$ are coupled between the external pins 11 and the ground.

Electrical power to the PROM chip 1, which is packaged, is supplied, via a parasitic inductor $L_{VCC}$ and a parasitic resistor $R_{VCC}$, from a power supply voltage $V_{VCC}$ supplied via a power supply line 12. Similarly, the ground terminal G inside of the internal circuit 2 is grounded via a parasitic inductor $L_{GND}$ and a parasitic resistor $R_{GND}$.

In a case where the external load $C_L$ has a large current capacitance, if the output buffers 4 - 6 have large absorption capabilities, an absorption current i rises the ground potential of the internal circuit 2 and/or the address buffer 3 due to the existence of parasitic elements, such as the parasitic inductor $L_{VCC}$ and the parasitic resistor $R_{VCC}$. The increased ground potential serves as a noise source with respect to the address (input) signal SA. Thus, the output signal obtained at the output pin 11 is not stable, and causes the device to malfunction. It should be noted that the logic is determined with respect to the ground potential of the ground terminal G. Thus, variations in the ground potential should be eliminated.

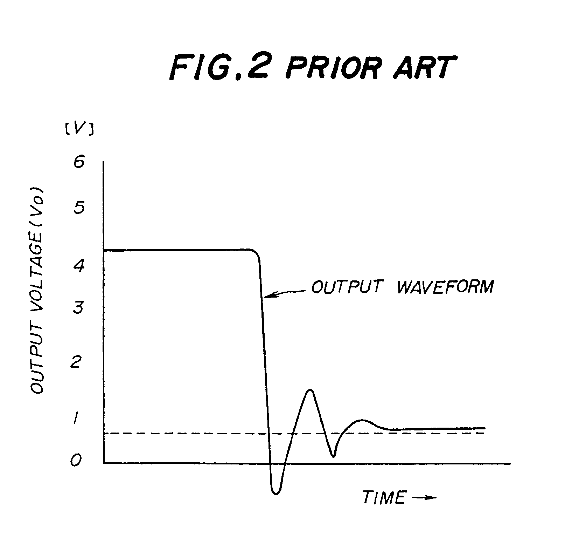

FIG.2 shows an output waveform obtained at the output pin 11 when Vcc = 5 volts (normal TTL level). When the output voltage now labeled Vo of the output pin 11 changes from a high level to a low level, a ringing occurs in the output waveform due to the existence of the parasitic inductor $L_{VCC}$ and/or the external capacitor $C_L$. The ringing is fed back to the internal circuit 2, which will malfunction. As the operation speed increases, the device more frequently malfunctions.

### SUMMARY OF THE INVENTION

It is a general object of the present invention to provide an improved semiconductor integrated circuit device in which the above-mentioned disadvantages are eliminated.

A more specific object of the present invention is to provide a semiconductor integrated circuit device which can correctly generate a stabilized output signal at a high speed.

The above-mentioned objects of the present invention are achieved by a semiconductor integrated circuit device comprising: a memory cell array having a plurality of memory cells; addressing means, coupled to the memory cell array, for decoding an address signal supplied from an external device and for outputting a decoded address to the memory cell array, information related to the decoded address being read out from the memory cell array; detection means for detecting a change in a predetermined signal and for outputting a detection pulse having a predetermined pulse width when the change is detected; sense amplifier means, coupled to the memory cell array, for amplifying the information and for outputting an amplified information signal; output means for setting an output terminal to either a first level or a second level in response to the amplified information signal; and intermediate level generating means, coupled to the detection means and the output terminal, for setting the output terminal to an intermediate potential during a period corresponding to the pulse width of the detection pulse, the intermediate potential being lower than the first level and higher than the second level.

### BRIEF DESCRIPTION OF THE DRAWINGS

Other objects, features and advantages of the present invention will become apparent from the following detailed description when read in conjunction with the accompanying drawings, in which:

FIG.1 is a circuit diagram of a conventional PROM;

FIG.2 is a waveform diagram of an output signal of the PROM shown in FIG.1;

FIG.3 is a circuit diagram illustrating the principle of the present invention;

FIG.4 is a block diagram of an ATD circuit shown in FIG.3;

FIG.5 is a waveform diagram illustrating the operation of the circuit shown in FIG.3;

FIG.6 is a circuit diagram of a circuit according to a first preferred embodiment of the present invention;

FIG.7 is a waveform diagram illustrating the operation of the circuit shown in FIG.6;

FIG.8 is a circuit diagram of a circuit according to a second preferred embodiment of the present invention; and

FIG.9 is a waveform diagram illustrating the operation of the circuit shown in FIG.8.

## DESCRIPTION OF THE PREFERRED EMBODIMENTS

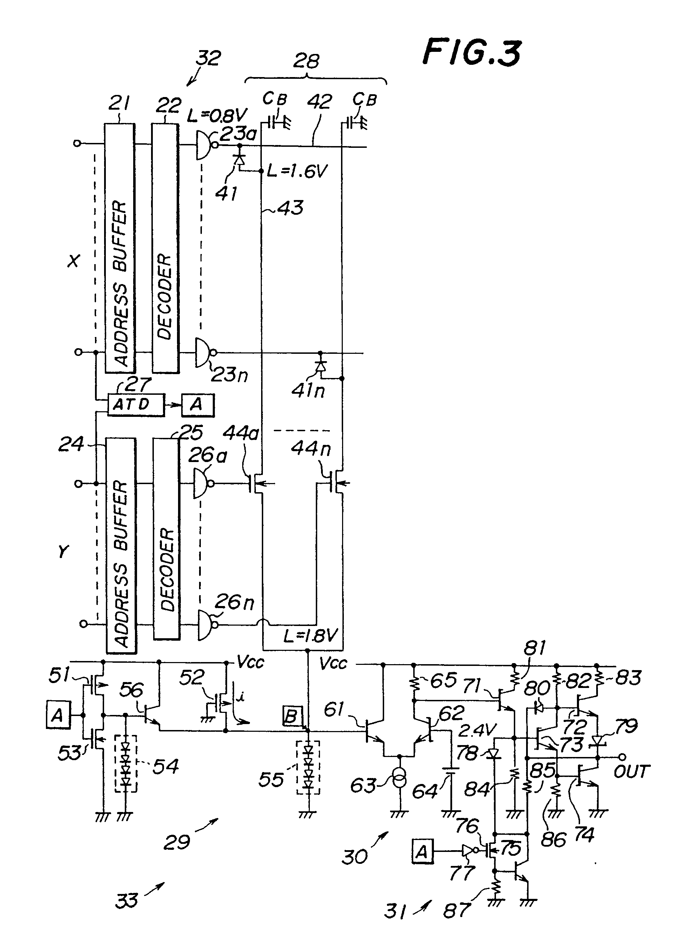

The principle of the present invention will now be described with reference to FIG.3, which shows a PROM. The PROM shown in FIG.3 includes an address buffer 21 related to rows (X) of an array 28 of memory cells, a decoder 22, word drivers 23a - 23n formed of Bi-CMOS circuits, an address buffer related to columns (Y) of the memory cell array 28, a decoder 25, bit drivers 26a - 26n, an address transition detector (hereafter referred to as an ATD circuit) 27, a signal correction circuit 29, a sense amplifier 30 and an output circuit 31. The address buffers 21 and 24, and the decoders 22 and 25 form an input circuit 32.

The ATD circuit 27 detects a change in an address signal consisting of bits to be supplied to the address buffers 21 and 24, and generates an address transition pulse (hereafter referred to as an ATD pulse) having a predetermined pulse duration of time. The ATD pulse is supplied to the signal correction circuit 29 and the output circuit 31 via a terminal A. The memory cell array 28 includes cell diodes 41a, ..., 41n (n is an integer), word lines 42, bit lines 43, and bit switch transistors 44a, ..., 44n. $C_B$ indicates floating capacitors coupled to the bit lines 43. The word drivers 23a - 23n select the corresponding word lines 42 by setting these word lines 42 to low levels (= 0.8 volts). The bit drivers 26a - 26n select the corresponding bit lines 43 by turning ON the corresponding bit switch transistors 44a, ..., 44n. The voltage drop developed across each of the bit switch transistors 44a, ..., 44n is equal to 0.2 volts.

The signal correction circuit 29 is composed of PMOS (p-channel MOS) transistors 51 and 52, an NMOS (n-channel MOS) transistor 53, clamp diodes 54 and 55, and an npn bipolar transistor 56. The signal correction circuit 29 subjects the logic signal to a clamp correction in response to the ATD pulse. The sense amplifier 30 includes transistors 61 and 62 which form a differential amplifier, a current source 63, a reference power source 64 and a resistor 65. The potential of the reference power source 64 is equal to, for example, 2.4 volts. The sense amplifier 30 amplifies information read out from the memory cell array 28 through the signal correction circuit 29, and sends amplified information to the output circuit 31. An internal circuit 33 is made up of the memory cell array 28, the word drivers 23a - 23n, the bit drivers 26a - 26n, the signal correction circuit 29 and the sense amplifier 30.

The output circuit 31 is composed of Schottky transistors 71 - 74, a normal npn bipolar transistor 75, an NMOS transistor 76, an inverter 77, Schottky diodes 78 and 79, a normal diode 80 and resistors 81 - 87. While the ATD pulse is being input to the output circuit 31, it maintains its output terminal OUT in a high-impedance state and pulls out a current to the ground side so that the potential of the output terminal OUT gradually decreases. When the inputting of the ATD pulse ends, the output circuit 31 changes, in response to the output of the sense amplifier 30, the output terminal OUT to a high level or a low level from the state where the current is being pulled out.

The above-mentioned circuits are externally supplied with a first power supply voltage Vcc (equal to, for example, 5 volts) and a second power supply voltage GND (for example, zero volt). The input circuit 32, the internal circuit 33 and the output circuit 31 are formed on a common semiconductor substrate.

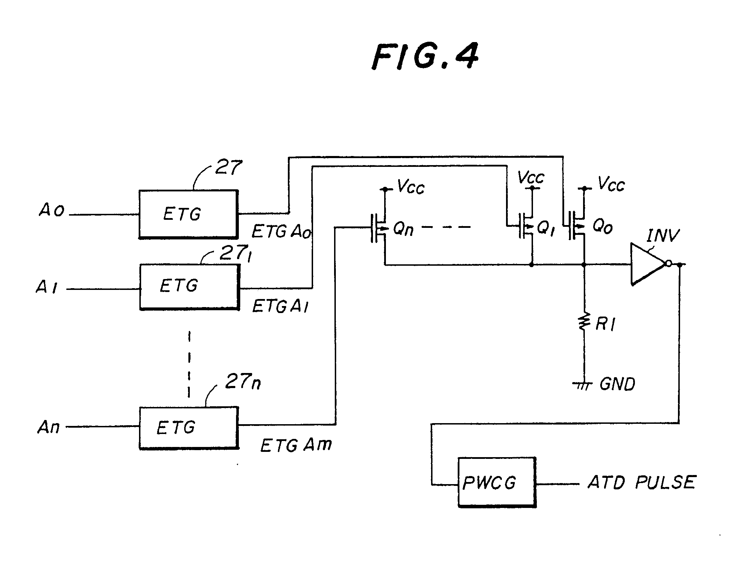

FIG.4 illustrates the structure of the ATD circuit 27. As shown, the ATD circuit 27 is composed of edge trigger circuits (ETG) $27_0$ - $27_n$, PMOS transistors $Q_0$ - $Q_n$, an inverter INV, a resistor R1 and a pulse width controller PWCG. The edge trigger circuits $27_0$ - $27_n$ detect changes of address bits $A_0$ - $A_n$, and output edge trigger signals $ETGA_0$ - $ETGA_n$ when they detect the address changes. When one of the address bits $A_0$ - $A_n$ is detected, the corresponding one of the PMOS transistors $Q_0$ - $Q_n$ is turned ON, so that the ATD pulse is output via the inverter INV and the pulse width controller PWCG. The pulse width of the ATD pulse is adjusted so that predetermined signal processes can be carried out during the time corresponding to the pulse width of the ATD pulse.

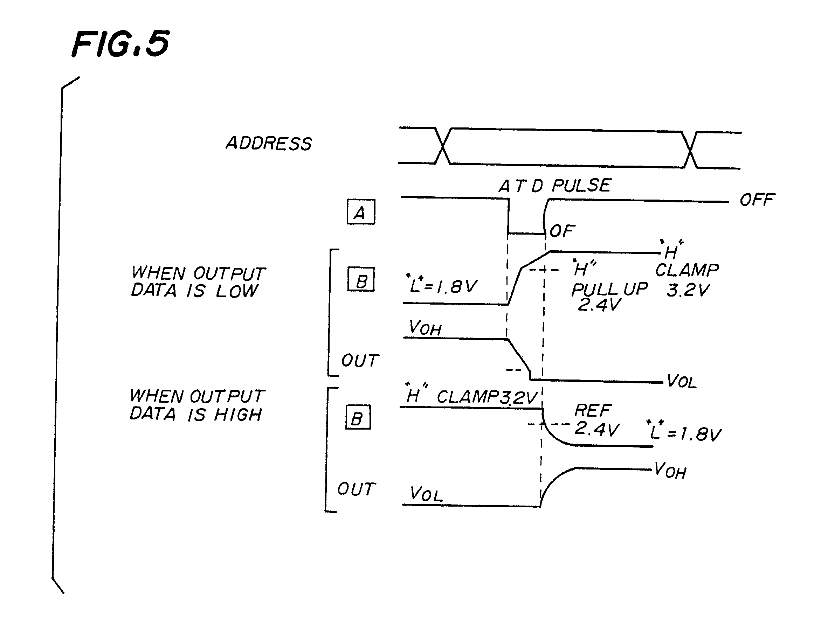

A description will now be given of the operation of the circuit shown in FIG.3 with respect to FIG.5. When the address signal is determined, it is input to the address buffers 21 and 24 and also input to the ATD circuit 27. Then, the ATD circuit 27 outputs the ATD pulse, as shown in FIG.5, which depicts the waveform of the ATD pulse obtained at the node A shown in FIG.3. The ATD pulse is input to the signal correction circuit 29 and the output circuit 31. In response to the ATD pulse, the bipolar transistor 56 of the signal correction circuit 29 is turned ON, so that the emitter follower circuit formed of the bipolar transistor 56 (the base thereof is clamped by the clamp diode 54) starts to operate and, as shown in FIG.5, the emitter voltage of the bipolar transistor 56 is increased to 2.4 volts from a level equal to 1.8 volts. However, a high-level holding current i passes through the PMOS transistor 52, so that as shown in FIG.5, a node B (which corresponds to the emitter of the bipolar diode 56) is immediately pulled up to 3.2 volts and claimed at this voltage.

On the other hand, the NMOS transistor 76 of the output circuit 31 is turned ON in response to the ATD pulse. Thus, the transistor 75 is turned ON and the Schottky transistors 72 and 73 are turned OFF. Further, the Schottky transistor 74 is turned OFF. Hence, the output terminal OUT is set to the high-impedance state. At this time, current is pulled out to the ground through the transistor 75 having a small driving ability, so that the potential of the output terminal OUT gradually decreases from the high level $(V_{OH})$ and finally becomes a potential nearly equal to the ground potential. When the ATD pulse ends, the output terminal OUT is released from the high-impedance state, and set to a level determined based on the output level of the sense amplifier 30.

On the other hand, the node B is set to the high level or low level on the basis of the information stored in the selected memory cell of the memory cell array 28. The sense amplifier 30 reads the level of the node B, and outputs the read level to the output circuit 31. When the output signal changes to the low level $(V_{OL})$ on the basis of the information read out through the sense amplifier 30, the output terminal OUT immediately changes to the low level from the potential nearly equal to the ground potential. On the other hand, when the output signal changes to the high level $(V_{OH})$ on the basis of the information read out through the sense amplifier 30, the output terminal OUT immediately changes to the high level from the potential nearly equal to the ground potential.

As has been described above, while the ATD pulse is being output, the current is being pulled out so that the output terminal OUT becomes nearly equal to the ground potential. It should be noted that the current is gradually pulled out so that it does not serve as a noise source coupled to the ground terminal. Thus, even if there are parasitic impedance elements, such as the parasitic inductor $L_{VCC}$ and the parasitic resistor $R_{VCC}$ resulting from the existence of a large external load $C_L$, an increase in the ground potential of the internal circuit 28 due to the passage of the absorption current does not take place. Thus, it is possible to prevent the parasitic inductor $L_{VCC}$ and the parasitic resistor $R_{VCC}$ serve as noise sources with respect to the input signal, so that the output signal can be stabilized and the circuit can operate correctly at a high speed.

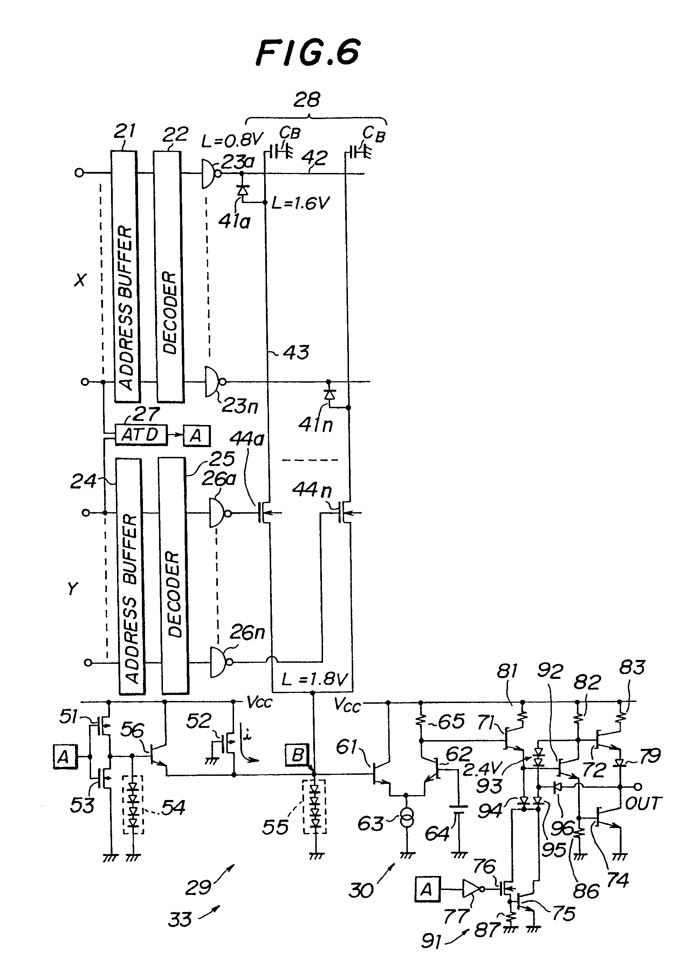

FIG.6 is a circuit diagram of a first preferred embodiment of the present invention. In FIG.6, those parts which are the same as those shown in the previous figures are given the same reference numerals. An output circuit 91 shown in FIG.6 is substituted for the output circuit 31 shown in FIG.3. The output circuit 91 is made up of a phase-splitter Schottky transistor 92, a level shift element 93 having two diodes connected in series, two Schottky diodes 94 and 95, and a normal diode 96. An intermediate level generation circuit is formed of the transistor 75 and the level shift element 93. Of course, the diode 95 slightly contributes to the setting of the intermediate level. The transistor 72 functions to charge a load (not shown) coupled to the output terminal OUT, and the transistor 74 functions to discharge the load. The inverter 77 and the NMOS transistor 76 function to set the output terminal OUT to the high-impedance state during the time the ATD pulse is ON.

The collector of the Schottky transistor 92 is connected to the base of the Schottky transistor 72, and the emitter of the Schottky transistor 92 is connected to the base of the Schottky transistor 74. The base of the Schottky transistor 92 is connected to the emitter of the Schottky transistor 71. The anode terminal of the level shift element 93 is connected to the collector of the Schottky transistor 92, and the cathode terminal thereof is connected to the anode terminal of the Schottky diode 95. The cathode of the Schottky diode 95 is connected to the collector of the transistor 75, and the cathode terminal of the Schottky diode 94. The anode terminal of the Schottky diode 94 is connected to the base of the Schottky transistor 92, and the cathode terminal thereof is connected to the drain of the NMOS transistor 76. The anode terminal of the diode 96 is connected to the output terminal OUT, and the cathode terminal thereof is connected to the anode terminal of the schottky diode 95.

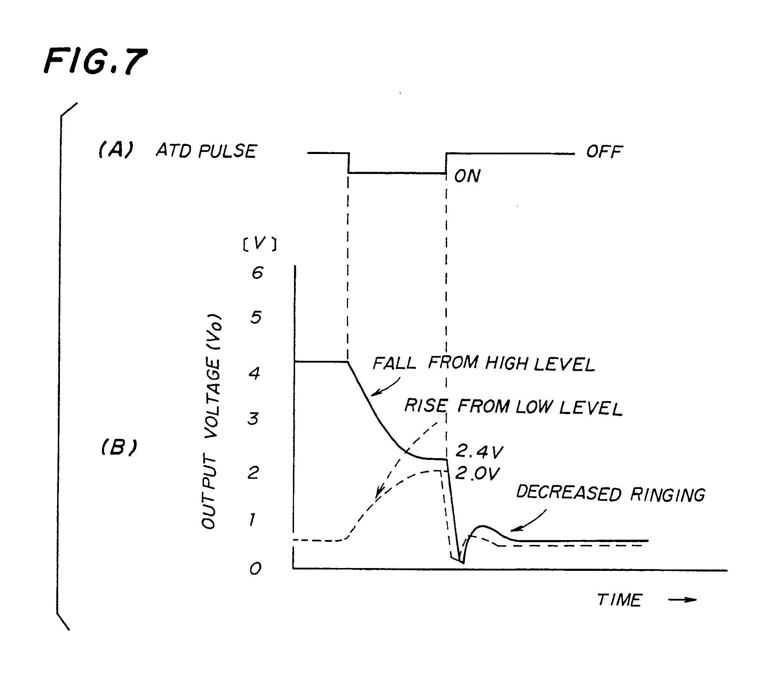

A description will now be given of the operation of the circuit shown in FIG.6 with reference to FIG.7, which shows the operation obtained when Vcc = 5.5 volts (which is the normal TTL level). In response to the ATD pulse, the NMOS transistor 76 is turned ON, and the transistor 75 is turned ON, so that the potential of the base of the Schottky transistor 92 decreases toward the ground side via the Schottky diode 94. Thus, the Schottky transistor 92 is turned OFF, and the transistor 74 is also turned OFF. The collector potential of the Schottky transistor 92 is pulled out to the ground side via the level shift element 93. However, it should be noted that the collector potential of the Schottky transistor 92 is not exactly equal to the ground potential due to the existence of the level shift element 93. As a result of the above operation, the transistor 72 is not completely turned OFF. Thus, as shown in FIG.7-(B), the potential of the output terminal OUT is maintained at an intermediate level approximately equal to 2.4 volts which is lower than the normal high level. This is due to the fact that the base potential of the Schottky transistor 72 is determined by the level shift element 93 which is determined from the ground level so that the intermediate level equal to 2.4 volts is not affected by the Vcc level. On the other hand, the output voltage rises from the low level and is maintained at the intermediate level approximately equal to 2 volts. Thus, even if the power supply voltage Vcc increases, the output increases up to a "high" level which is higher than the ground potential by a constant level. When the ATD pulse ends in this state, the output terminal OUT becomes a level determined by the output level of the sense amplifier 30. When the output voltage decreases to the low level, the decreasing of the output voltage starts from the intermediate level which is lower than the normal high level. Thus, as shown in FIG.7, the occurrence of ringings and noise resulting therefrom is extremely suppressed. As a result, the output voltage can be stabilized at a high speed.

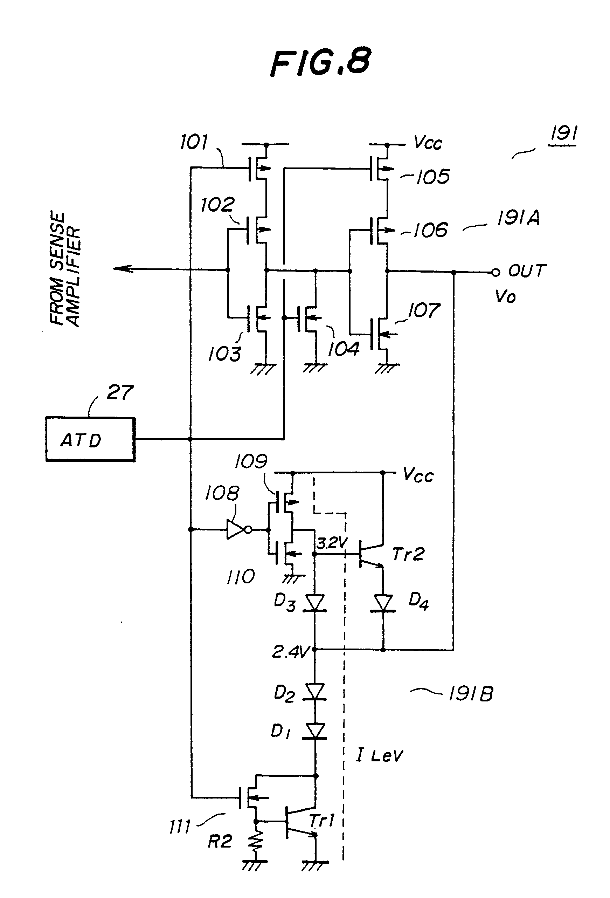

A description will now be given of a second preferred embodiment of the present invention with reference to FIG.8, which shows an output circuit 191 which is substituted for the output circuit 91 shown in FIG.6. The output circuit 191 is a CMOS type circuit. The output circuit 191 includes a buffer circuit composed of MOS transistors 101 - 107, and an intermediate level generation circuit 191B composed of an input inverter 108, MOS transistors 109 - 111, bipolar transistors Tr1 and Tr2, normal diodes D1 - D3, a Schottky diode D4 and a resistor R2. The intermediate level generation circuit 191B is connected in parallel to the buffer circuit 191A.

The ATD pulse is applied to the base of the transistor Tr2 via the input inverter 108 and a CMOS inverter consisting of the MOS transistors 109 and 110. The collector of the transistor Tr2 is connected to the Vcc power supply line, and the emitter thereof is connected to the anode terminal of the Schottky diode D4. The cathode terminal of the Schottky diode D4 is connected to the output terminal OUT. A series circuit consisting of the diodes D1, D2 and D3 connected in series is connected between the output of the CMOS inverter and the collector of the transistor Tr1. The intermediate level setting of the intermediate level generation circuit 191B is based on the diodes D1 - D4 and the transistors Tr1 and Tr2. The cathode terminals of the diodes D3 and D4 are mutually connected. The emitter of the transistor Tr1 is grounded, and the base thereof is connected to the source of the MOS transistor 111, which receives the ATD pulse 27 via the gate thereof. The source of the MOS transistor 111 is grounded via the resistor R2.

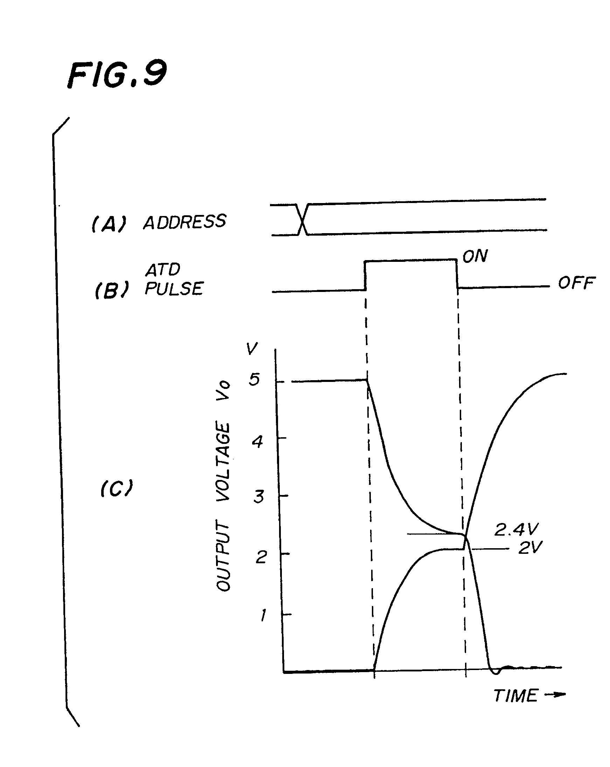

A description will now be given of the operation of the circuit shown in FIG.8 with reference to FIG.9. While the ATD pulse is input to the buffer circuit 191A, the PMOS transistors 101 and 105 are maintained in the OFF state, so that the input signal from the sense amplifier (not shown in FIG.8) is inhibited, and the output terminal OUT is held in the high-impedance state. On the other hand, when the ATD pulse is input to the CMOS inverter via the inverter 108, the PMOS transistor 109 of the CMOS inverter is turned ON, so that a current $I_{LEV}$ passes through the PMOS transistor 109, the diodes D3 - D1 and the transistor Tr1. Thus, the base potential of the transistor Tr2 is set to approximately 3.2 volts. When the previous state of the output voltage of the output terminal OUT is low, it is increased to an intermediate level approximately equal to 2 volts during the time when the ATD pulse is ON. On the other hand, when the previous state of the output voltage of the output terminal OUT is high, it is decreased to the intermediate level approximately equal to 2.4 volts during the time the ATD pulse is ON. After the ATD pulse is OFF, the output voltage of the output terminal OUT is determined on the basis of the data read out from the sense amplifier circuit 30 shown in FIG.6.

The present invention is not limited to the specifically disclosed embodiments, and variations and modifications may be made without departing from the scope of the present invention.

## Claims

1. A semiconductor integrated circuit device including:

a memory cell array (28) having a plurality of memory cells;

addressing means (21, 22, 24, 25), coupled to said memory cell array, for decoding an address signal supplied from an external device and for outputting a decoded address to said memory cell array, information related to said decoded address being read out from said memory cell array;

detection means (27) for detecting a change in a predetermined signal and for outputting a detection pulse (ATD) having a predetermined pulse width when said change is detected;

sense amplifier means (30), coupled to said memory cell array, for amplifying said information and for outputting an amplified information signal; and

output means (91; 191A) for setting an output terminal (OUT) to either a first level ($V_{OH}$) or a second level ($V_{OL}$) in response to said amplified information signal,

characterized in that said semiconductor integrated circuit device comprises intermediate level generating means (75, 93; 191B), coupled to said detection means and said output terminal, for setting said output terminal to an intermediate level during a period corresponding to said pulse width of said detection pulse, said intermediate level being lower than said first level and higher than said second level.

2. A semiconductor integrated circuit device as claimed in claim 1, characterized in that said output means comprises:

a first transistor (72) having a collector coupled to a first power supply line (Vcc), an emitter coupled to said output terminal, and a base;

a second transistor (74) having a collector coupled to said output terminal, an emitter coupled to a second power supply line (GND), and a base; and

a third transistor (92) having a collector coupled to the base of said first transistor, an emitter coupled to the base of said second transistor, and a base coupled to said sense amplifier means, and

that said intermediate level generating means comprises control means (75, 93) for generating a base potential of said first transistor from a power supply voltage (GND) via said second power supply line during said period so that a slight current passes from said first power supply line to said output terminal through said first transistor.

3.  A semiconductor integrated circuit device as claimed in claim 2, said control means comprises:

level shift means (93, 95) for generating a predetermined level from said power supply voltage via said second power supply line, said predetermined level causing said first transistor to pass said slight current and being applied, as said base potential of said first transistor, to the base of said first transistor; and

switching means (75) for connecting said level shift means coupled to the base of said first transistor said second power supply lines during said period.

4.  A semiconductor integrated circuit device as claimed in claim 3, characterized in that said level shift means comprises at least one level shift diode having an anode coupled to the base of said first transistor and a cathode coupled to said switching means.

5.  A semiconductor integrated circuit device as claimed in claim 4, characterized in that said output means (91) comprises a diode (96) having an anode coupled to said output terminal and a cathode coupled to the cathode of said level shift diode.

6.  A semiconductor integrated circuit device as claimed in claim 3, characterized in that said switching means comprises a fourth transistor (75) having a collector coupled to said level shift means, an emitter coupled to said second power supply line, and a base controlled by said detection pulse.

7.  A semiconductor integrated circuit device as claimed in claim 2, characterized in that said output means comprises high-impedance setting means (76, 77) for turning OFF said third transistor (92) during said period so that said output terminal is set to a high-impedance state.

8.  A semiconductor integrated circuit device as claimed in any of claims 1 to 7, characterized in that said first, second and third transistors (72, 74, 92) are bipolar transistors.

9.  A semiconductor integrated circuit device as claimed in claim 1, characterized in that:

said output means comprises a transistor (72) having a collector coupled to a first power supply line (Vcc), an emitter coupled to said output terminal, and a base, and

that said intermediate level generating means (75, 93) comprises control means (75, 93) for generating a base potential of said first transistor from a power supply voltage (GND) via a second power supply line (GND) during said period so that a slight current passes from said first power supply line to said output terminal through said first transistor.

10. A semiconductor integrated circuit device as claimed in claim 9, characterized in that said output means comprises a Schottky diode (79) having an anode coupled to the emitter of said transistor, and a cathode coupled to said output terminal.

11. A semiconductor integrated circuit device as claimed in claim 1, characterized in that:

said output means comprises CMOS inverter means (191A) for receiving said amplified information signal and for setting said output terminal to one of said first level and said second level in response to said amplified information signal, and

that said intermediate level generating means (191B) comprises:

a first transistor (Tr2) having a collector coupled to a first power supply line (Vcc), an emitter coupled to said output terminal, and a base; and

control means (D1-D3, Tr1) for generating a base potential of said first transistor from a power supply voltage (GND) via a second power supply line (GND) during said period so that a slight current passes from said first power supply line to said output terminal through said first transistor.

12. A semiconductor integrated circuit device as claimed in claim 11, characterized in that said intermediate level generating means (191B) comprises:

level shift means (D1-D3) for generating a predetermined level from said power supply voltage (GND) via said second power supply line, said predetermined level causing said first transistor to pass said slight current and being applied, as said base potential of said first transistor, to the base of said first transistor; and

switching means (Tr1) for connecting said level shift means coupled to the base of said first transistor to said second power supply line (GND) during said period.

13. A semiconductor integrated circuit device as claimed in claim 12, characterized in that said level shift means comprises at least one level shift diode (D1-D3) having an anode coupled to the base of said first transistor and a cathode coupled to said switching means.

14. A semiconductor integrated circuit device as claimed in claim 13, characterized in that said output means comprises a diode (D4) having an anode coupled to said output terminal and a cathode coupled to the cathode of said level shift diode.

15. A semiconductor integrated circuit device as claimed in claim 12, characterized in that said switching means comprises a second transistor (Tr1) having a collector coupled to said level shift means, an emitter coupled to said second power supply line, and a base controlled by said detection pulse.

16. A semiconductor integrated circuit device as claimed in claim 11, characterized in that said output means comprises high-impedance setting means (101, 105, 108-111) for turning OFF said first transistor and for making said CMOS inverter means inactive during said period so that said output terminal is set to a high-impedance state.

17. A semiconductor integrated circuit device as claimed in claim 11, characterized in that said first transistor (Tr2) is a bipolar transistor.

18. A semiconductor integrated circuit as claimed in any of claims 1 to 17, characterized in that:

said detection means (72) comprises address change detection means (72) for detecting a change in said address signal; and

said detection means outputs said detection pulse (ATD) when said address change detection means detects said change in said address signal.

# FIG.I PRIOR ART

# FIG.2 PRIOR ART

OUTPUT WAVEFORM

OUTPUT VOLTAGE (Vo)

[V]

6  5  4  3  2  1  0

TIME →

# FIG.3

# FIG.4

EP 0 447 242 A2

# FIG.5

ADDRESS

ATD PULSE

A     OFF

OF

WHEN OUTPUT
DATA IS LOW

B

"L"=1.8V     "H"
    PULL UP    "H"
    2.4V    CLAMP 3.2V

V_OH

OUT       V_OL

WHEN OUTPUT
DATA IS HIGH

B

"H" CLAMP3.2V    REF
    2.4V    "L"=1.8V

OUT   V_OL       V_OH

EP 0 447 242 A2

13

# FIG.6

# FIG.7

(A)  ATD PULSE ——————————————— OFF

ON

(B)

**OUTPUT VOLTAGE (Vo)**  [V]

6

5

4  — FALL FROM HIGH LEVEL

3  — RISE FROM LOW LEVEL

2.4V
2  2.0V

DECREASED RINGING

1

0

TIME ⟶

EP 0 447 242 A2

# FIG.8

# FIG.9

(A) ADDRESS

(B) ATD PULSE

ON

OFF

(C)

OUTPUT VOLTAGE $V_0$

V

5

4

3

2

1

2.4V

2V

TIME →